# FASCICULE DE BREVET EUROPEEN

(11) **EP 0 214 693 B1**
(45) Date de publication et mention de la délivrance du brevet: **15.12.1993**
(21) Numéro de dépôt: 86201498.2
(22) Date de dépôt: 01.09.1986
(51) Int. Cl.: H03L 1/00, H05K 7/14

(54) **Oscillateur hyperfréquence à résonateur diélectrique, insensible aux vibrations mécaniques**
Hyperfrequenz-Oszillator mit für mechanische Vibrationen unempfindlichem dielektrischem Resonator
Microwave oscillator with a dielectric resonator which is insensitive to mechanical vibrations

(30) Priorité: 06.09.1985 FR 8513315
(43) Date de publication de la demande: 18.03.1987
(73) Titulaire: PHILIPS COMPOSANTS, 92150 Suresnes (FR); Philips Electronics N.V., 5621 BA Eindhoven (NL)
(72) Inventeur: Doyen, Daniel, F-75007 Paris (FR); Vriz, Tarcisio, F-75007 Paris (FR)
(74) Mandataire: Pinchon, Pierre

(56) Documents cités:
- DE-A- 3 043 508
- GB-A- 832 591
- US-A- 3 089 062
- US-A- 4 032 204
- US-A- 4 079 341
- INTERNATIONAL JOURNAL OF ELECTRONICS, vol. 55, no. 4, octobre 1983, pages 579-590, Basingstoke, Hampshire, GB; A. DIB et al.: "AN X-band integrated circuit FET oscillator with dielectric resonator stabilization"
- INTERNATIONAL JOURNAL OF ELECTRONICS, vol. 55, no. 6, décembre 1983, pages 805-810, Basingstoke, Hampshire, GB; D. SINGH et al.: "A stabilized common-drain GaAs FET oscillator using a dielectric resonator in the 7 GHz band"
- MICROWAVE JOURNAL, vol. 24, no. 11, novembre 1981, pages 103, 104, 106, 108, Dedham, Massachusetts, US; M. PURNELL: "The dielectric resonator oscillator - A new class of microwave signal source"

## Description

La présente invention concerne un oscillateur hyperfréquence stabilisé par résonateur diélectrique, constitué, d'une part, d'un boitier enfermant le circuit à résonateur diélectrique et comportant une face de fixation, et, d'autre part, un support comportant une face extérieure sur laquelle est fixé le boitier.

Le développement de nouveaux matériaux à forte constante diélectrique (Titanate de Baryum ou de Zirconium) et présentant de très faibles pertes hyperfréquence ainsi que des coefficients de température nuls ou légèrement positifs, a conduit à la réalisation d'une nouvelle génération d'oscillateurs hyperfréquence : les oscillateurs stabilisés par résonateur diélectrique. Ces oscillateurs fonctionnent à fréquence fixe ou légèrement ajustable et sont caractérisés par une grande stabilité de fréquence et de niveau de sortie en fonction de la température, un bon rendement électrique grâce à l'emploi de transistors à effet de champ, une bonne pureté de spectre et la possibilité d'utiliser la technologie des microbandes permettant un faible poids et un faible volume. Un tel oscillateur est connu de "International Journal of Electronics"; vol 55, no 4, octobre 1983. pp. 579-590; Basingstoke, Hampshire, Dib et al. "An x-band integrated circuit FET oscillator with dielectric resonator stabilisation".

Ce type d'oscillateurs trouvent de nombreuses applications en instrumentation, télécommunication, radars, et.... Dans certaines utilisations, une certaine pureté spectrale du signal hyperfréquence doit être conservée en régime de vibrations aléatoires. La technologie de montage doit donc être adaptée à ces contraintes et, plus particulièrement, le résonateur diélectrique doit être solidement fixé sur son circuit et l'environnement métallique et diélectrique de ce résonateur très rigide et stable puisque toute variation des plans métalliques qui entourent le résonateur diélectrique engendre des variations de la fréquence d'oscillation. Notamment, la distance h séparant le résonateur diélectrique du couvercle du boîtier est très critique à cet égard. La Demanderesse a montré, par exemple, que, pour une distance h de 3 mm, une simple variation différentielle Δ h de quelques dizaines de 10⁻³ µm provoquait une dégradation du bruit de phase d'environ 15 dB à 1 kHz de la fréquence de l'oscillateur centrée à14 GHz. D'où l'importance de concevoir un boîtier extrêmement rigide que le seul renfort des épaisseurs métalliques ne permet pas de réaliser sauf à augmenter de façon pénalisante le poids et le volume du boîtier.

L'invention a pour but de remédier à cet inconvénient en proposant un oscillateur présentant une sensibilité fortement réduite aux vibrations appliquées sur son support sans augmentation du poids et du volume du boîtier.

En effet, selon la présente invention, un oscillateur hyperfréquence stabilisé par résonateur diélectrique, constitué, d'une part, d'un boîtier enfermant le circuit à résonateur diélectrique et comportant une face de fixation, et, d'autre part, un support comportant une face extérieure sur laquelle est fixé le boîtier, est notamment remarquable en ce que l'interface boîtier-support présente des moyens de portée, tels que le boîtier est mis en contrainte de flexion lorsqu'il est fixé et bloqué par sa face de fixation sur la face extérieure du support, tandis que la face de fixation du boîtier et la face extérieure du support restent en contact mécanique et électrique l'une par rapport à l'autre. Ainsi mis en contrainte, le boîtier offre une bien meilleure rigidité et une moindre sensibilité aux vibrations appliquées au support.

La description qui va suivre, en regard des dessins annexés donnés à titre d'exemples non limitatifs, fera bien comprendre en quoi consiste l'invention et comment elle peut être réalisée.

La figure 1 montre en coupe, un premier mode de réalisation d'un oscillateur hyperfréquence selon l'invention.

La figure 2 montre en coupe un deuxième mode de réalisation d'un oscillateur hyperfréquence selon l'invention.

La figure 3 montre en coupe un troisième mode de réalisation d'un oscillateur hyperfréquence selon l'invention.

La figure 4 montre en coupe un quatrième mode de réalisation d'un oscillateur hyperfréquence selon l'invention.

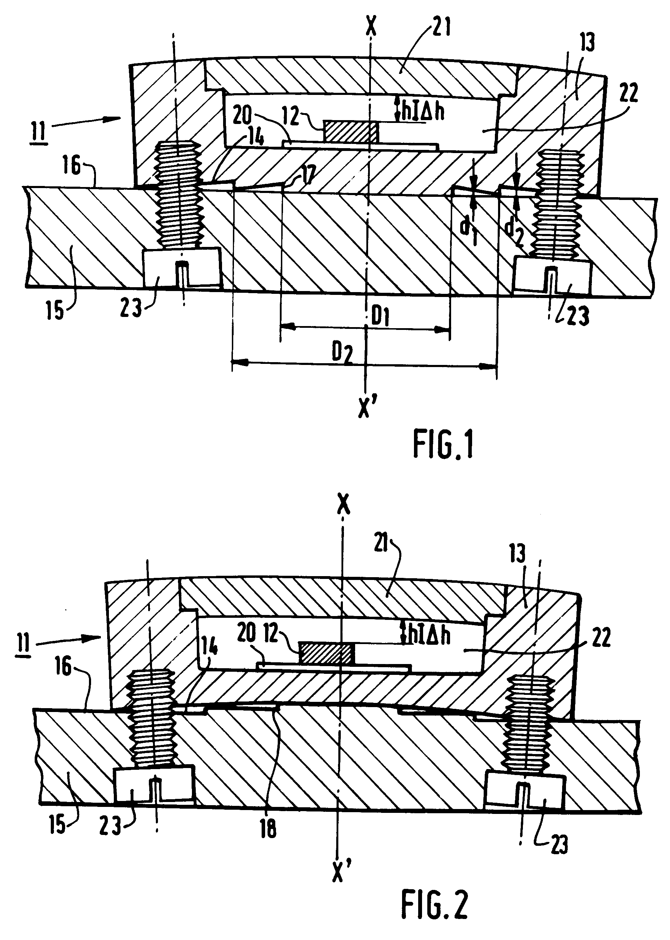

L'oscillateur hyperfréquence 11 représenté en coupe à la figure 1 est du type à résonateur diélectrique 12. Il est constitué d'un boîtier circulaire 13 enfermant le circuit 20 à résonateur diélectrique, ce circuit étant, avantageusement, réalisé selon la technologie des microrubans. Le boîtier 13 comporte également un couvercle 21 que enferme hermétiquement le circuit 20 après que celui-ci ait été mis en place et qui constitue, avec les autres parois du boîtier 13, la cavité hyperfréquence 22. Le boîtier 13 présente, par ailleurs, une face 14 de fixation. D'autre part, l'oscillateur hyperfréquence 11 est constitué d'un support 15 comportant une face extérieure 16 sur laquelle est fixé le boîtier 13 à l'aide, par exemple, de vis 23.

Le boîtier 13 est réalisé de façon très rigide afin que, sous l'effet de vibrations appliquées au support 15 de l'oscillateur, l'environnement mécanique du résonatuer diélectrique 12, qui participe à la détermination de la fréquence d'oscillation, varie le moins possible. Cependant, comme cela a été indiqué plus haut, l'oscillateur hyperfréquence 11 de la figure 1 reste néanmoins extrêmement sensible aux vibrations du support appliquées dans la direction XX', c'est à dire perpendiculairement à la surface du circuit 20. Dans le but de diminuer cette sensibilité, il est prévu, ainsi que le montre la figure 1, que l'interface boîtier 13 - support 15 présente des moyens de portée qui, dans le cas de la figure 1, sont constitués par un profil 17 en relief porté par la face 14 de fixation. L'exemple de la figure 1 propose un profil 17 en relief particulier réalisé par usinage de 2 bossages concentriques de diamètres D1, D2 et d'épaisseurs d1, d2 respectivement. Lorsqu'il est fixé et bloqué par sa face 14 de fixation sur la face extérieure 16 du support 15, le boîtier 13 est ainsi mis dans un état de contrainte de flexion qui lui permet d'offrir une plus grande résistance aux vibrations auxquelles est soumis le support 15 et assurant en même temps un contact mécanique et électrique optimum au niveau de l'interface boîtier-support. Dans ce but, les moyens de portée (ici les bossages) doivent être particulièrement adaptés à la géométrie du boîtier, à son système de fixation, au serrage des vis, ainsi qu'à la nature des matériaux du boîtier et du support. La Demanderesse a réalisé un oscillateur hyperfréquence 11 conforme à l'invention qui, pour un diamètre total de 37 mm du boîtier 13 présentait un premier bossage de 22 mm de diamètre D2 pour 25 um d'épaisseur d2 et un deuxième bossage de 14 mm de diamètre D1 pour 25 um d'épaisseur d1. L'essai réalisé à une fréquence d'oscillation de 14 GHz sur cet oscillateur a montré une amélioration de 20 db sur le bruit de phase pour des vibrations de 20 g dans la bande de 20 à 2000 Hz appliquées selon l'axe XX'.

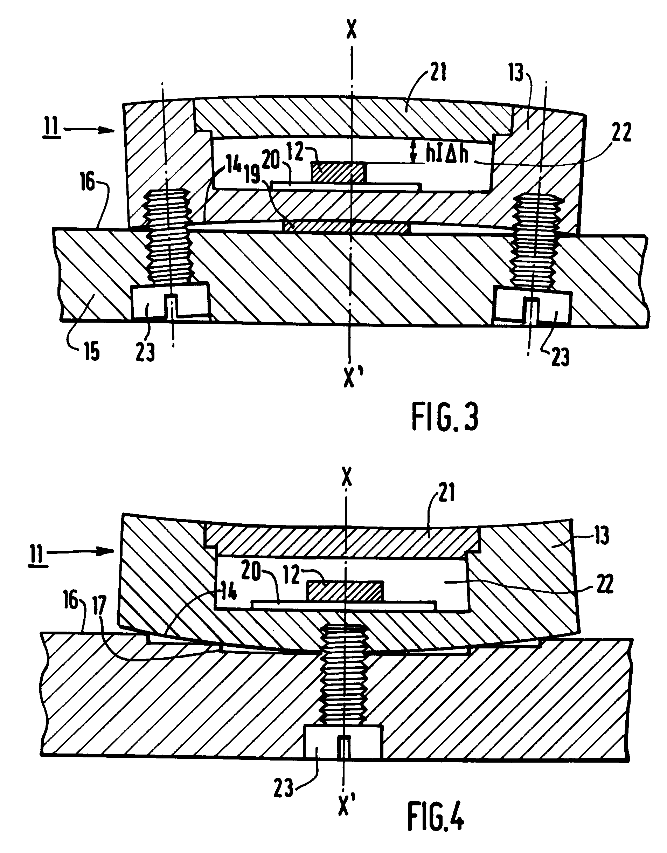

La figure 2 représente, vu en coupe, un deuxième mode de réalisation de l'oscillateur hyperfréquence selon l'invention dans lequel lesdits moyens de portée sont constitués par un profil 18 en relief porté, cette fois, par la face extérieure 16 du support 15. Les effets produits par ce mode particulier d'exécution sont évidemment identiques à ceux produits par l'exemple montré précédemment en relation avec la figure 1. De même, on envisage également, comme le montre la figure 3, que lesdits moyens de portée sont constitués par une cale 19 d'épaisseur interposée entre la face 14 de fixation du boîtier 13 et la face extérieure 16 du support 15. Dans cet exemple également, la géométrie de la cale 19 doit être telle qu'elle assure un bon contact mécanique et électrique entre le boîtier 13 et le support 15.

Enfin, il convient de souligner que l'invention ne saurait être limitée aux exemples montrés aux figu res 1, 2 et 3 mettant en oeuvre des moyens de portée réalisés par des bossages discontinus. Il serait en effet à la portée de l'homme de métier d'imaginer d'autres moyens de portée présentant un relief continu ou quasi continu tel qu'une calotte sphérique ou un tronc de cône. L'essentiel, en effet, est de créer des contraintes sur les parois métalliques du boîtier pour en augmenter la rigidité et d'assurer à la fois un parfait contact mécanique et électrique entre la face de fixation du boîtier et la face extérieure du support.

Selon une variante de mise en oeuvre de l'invention, non représentée sur les figures, le boîtier peut encore présenter une face de fixation qui soit plane à l'origine analogue à la face 14 de fixation des figures 2, 3 ou 4, alors que le support présente une face extérieure également plane analogue à la face extérieure 16 du support 15 représenté à la figure 1. Le boîtier est fixé au moyen de vis analogues aux vis 23 des figures. Toutefois, selon cette variante, lesdits moyens de portée plaçant le boîtier sous contrainte sont alors constitués par des vis auxiliaires de pression, judicieusement réparties sur le support, concentriquement par rapport à l'ensemble des vis de fixation, vis auxiliaires dont l'extrémité vient en appui avec une force déterminée sur la face de fixation du boîtier.

Par ailleurs, il faut aussi préciser que l'invention est indifférente au sens de la concavité produite par la flexion sur le boîtier. Ainsi que l'indique la figure 4, on peut envisager que les moyens de portée agissent sur les bords du boîtier 13 avec serrage dans la partie centrale du boîtier.

## Revendications

1. Oscillateur hyperfréquence (11) stabilisé par résonateur diélectrique (12), constitué, d'une part, d'un boîtier (13) enfermant le circuit à résonateur diélectrique et comportant une face (14) de fixation, et, d'autre part, un support (15) comportant une face extérieure (16) sur laquelle est fixé le boîtier (13), caractérisé en ce que l'interface boîtier (13) - support (15) présente des moyens (17, 18, 19) de portée, tels que le boîtier (13) est mis en contrainte de flexion lorsqu'il est fixé et bloqué par sa face (14) de fixation sur la face extérieure (16) du support (15), tandis que la face (14) de fixation du boîtier et la face extérieure (16) du support restent en contact mécanique et électrique l'une par rapport à l'autre.

2. Oscillateur hyperfréquence selon la revendication 1, caractérisé en ce que lesdits moyens de portée sont constitués par un profil (17) en relief porté par la face (14) de fixation du boîtier (13).

3. Oscillateur hyperfréquence selon la revendication 1, caractérisé en ce que lesdits moyens de portée sont constitués par un profil (18) en relief porté par la face extérieure (16) du support (15).

4. Oscillateur hyperfréquence selon la revendication 1, caractérisé en ce que lesdits moyens de portée sont constitués par une cale (19) d'épaisseur interposée entre la face (14) de fixation du boîtier (13) et la face extérieure (16) du suppport (15).

5. Oscillateur hyperfréquence selon la revendication 1, caractérisé en ce que lesdits moyens de portée sont constitués par des vis auxiliaires de pression, réparties sur le support (15) dont l'extrémité vient en appui avec une force déterminée sur la face (14) de fixation du boîtier.

## Claims

1. A microwave oscillator (11) stabilized by a dielectric resonator (12) constituted on the one hand by a housing (13) accommodating the dielectric resonator circuit and having a fixing surface (14) and on the other hand by a support (15) having an outer surface (16), on which the housing (13) is secured, characterized in that the interface between the housing (13) and the support (15) has carrying means (17, 18, 19) such that the housing (13) is subjected to flexural strain when it is fixed and blocked by its fixing surface (14) on the outer surface (16) of the support (15), while the fixing surface (14) of the housing and the outer surface (16) of the support remain in mechanical and electrical contact with each other.

2. A microwave oscillator as claimed in Claim 1, characterized in that the said carrying means are constituted by a profile (17) in relief carried by the fixing surface (14) of the housing (13).

3. A microwave oscillator as claimed in Claim 1, characterized in that the said carrying means are constituted by a profile (18) in relief carried by the outer surface (16) of the support (15).

4. A microwave oscillator as claimed in Claim 1, characterized in that the said carrying means are constituted by a wedge (19) having a given thickness interposed between the fixing surface (14) of the housing (13) and the outer surface (16) of the support (15).

5. A microwave oscillator as claimed in Claim 1, characterized in that the said carrying means are constituted by auxiliary pressure screws which are distributed over the support (15) and whose ends bear with a given force on the fixing surface (14) of the housing.

## Patentansprüche

1. Von einem dielektrischen Resonator (12) stabilisierter Mikrowellen-Oszillator (11), der einerseits aus einem Gehäuse (13), das die dielektrische Resonatorschaltung einschließt und eine Befestigungsfläche (14) enthält, und andererseits aus einem Träger (15) besteht, auf dessen Außenfläche (16) das Gehäuse (13) befestigt ist, dadurch gekennzeichnet, daß die Gehäuse (13)/Träger (15)-Schnittstelle derartige Spannmittel (17, 18, 19) enthält, daß das Gehäuse (13) eine Biegungsspannung erfährt, wenn es durch seine Befestigungsfläche (14) auf der Außenfläche (16) des Trägers (15) befestigt und verriegelt wird, während die Befestigungsfläche (14) des Gehäuses und die Außenfläche (16) des Trägers miteinander in mechanischem und elektrischem Kontakt bleiben.

2. Mikrowellen-Oszillator nach Anspruch 1, dadurch gekennzeichnet, daß die Spannmittel aus einem Profil (17) in Relief auf der Befestigungsfläche (14) des Gehäuses (13) bestehen.

3. Mikrowellen-Oszillator nach Anspruch 1, dadurch gekennzeichnet, daß die Spannmittel aus einem Profil (18) in Relief auf der Außenfläche (16) des Trägers (15) bestehen.

4. Mikrowellen-Oszillator nach Anspruch 1, dadurch gekennzeichnet, daß die Spannmittel aus einem dicken Keil (18) zwischen der Befestigungsfläche (14) des Gehäuses (13) und der Außenfläche (16) des Trägers (15) bestehen.

5. Mikrowellen-Oszillator nach Anspruch 1, dadurch gekennzeichnet, daß die Spannmittel aus Hilfs-Druckbolzen bestehen, die auf den Träger (15) verteilt sind, deren Ende sich mit einer vorgegebenen Kraft auf der Befestigungsfläche (14) des Gehäuses abstützen.
